# EUROPEAN PATENT SPECIFICATION

(11) **EP 2 068 378 B1**
(45) Date of publication and mention of the grant of the patent: **01.08.2012**
(21) Application number: 08020371.4
(22) Date of filing: 22.11.2008
(51) Int. Cl.: H01L 33/00, G02F 1/13357, H01L 25/075

(54) **LED backlight for a liquid crystal display device**
LED Rückbeleuchtung für Flüssigkristallanzeigevorrichtung
Rétroéclairage par DEL pour un dispositif d'affichage à cristaux liquides

(30) Priority: 05.12.2007 KR 20070125673
(43) Date of publication of application: 10.06.2009
(73) Proprietor: Samsung Electronics Co., Ltd., Yeongtong-gu Suwon-city, Gyeonggi-do 442-742 (KR)
(72) Inventor: Park, Se-Ki, Gyeonggi-do (KR); Jeon, Eun-Chae, Seoul (KR); Kim, Gi-Cherl, Gyeonggi-do (KR); Kim, Jeom-Oh, Jeollabuk-do (KR)
(74) Representative: Weitzel, Wolfgang

(56) References cited:
- US-A1- 2005 174 544
- US-A1- 2007 099 325
- US-A1- 2007 189 011
- US-A1- 2007 228 386
- US-A1- 2007 242 477

## Description

This application claims priority to Korean Patent Application No. 10-2007-0125673, filed on December 5, 2007.

### BACKGROUND OF THE INVENTION

### 1. Field of the Invention

The present invention relates to a light-emitting device, a method of manufacturing the light-emitting device, and a liquid crystal display ("LCD") having the light-emitting device. More particularly, the present invention relates to a light-emitting device capable of improving the mixing of light generated by light-emitting chips and the dissipation of heat generated by light-emitting chips, a method of manufacturing the light-emitting device, and an LCD having the light-emitting device.

### 2. Description of the Related Art

Liquid crystal displays ("LCDs") are one of the most widely used flat panel displays ("FPDs"). In general, LCDs include two panels having a plurality of electrodes and a liquid crystal layer interposed between the two panels. LCDs adjust the amount of light that transmits through a liquid crystal layer by applying voltages to electrodes so that liquid crystal molecules in the liquid crystal layer can be rearranged.

Liquid crystal molecules can vary the transmittance of light according to the direction and intensity of an electric field applied thereto. Therefore, LCDs require light to display an image. Light-emitting diodes ("LEDs"), cold cathode fluorescent lamps ("CCFLs"), or flat fluorescent lamps ("FFLs") may be used as light sources of LCDs.

CCFLs have been most widely used in conventional LCDs. Recently, an increasing number of LCDs are being equipped with LEDs which consume less power and provide high luminance.

LEDs are arranged on a substrate and emit light toward the bottom of a liquid crystal panel. LEDs generate white light by mixing different color beams. As the size of liquid crystal panels increases, the number of LEDs required for an LCD has gradually increased, and therefore the more heat the LCD generates.

The document US 2007/0242477 A discloses such an LED arrangement having the features of the preamble of claim 1.

### BRIEF SUMMARY OF THE INVENTION

It has been determined herein, according to the present invention, that in order to improve the luminance of white light and the efficiency of the generation of white light, it is necessary to improve the mixing of light generated by LEDs and the dissipation of heat generated by LEDs.

The present invention provides a light-emitting device which is capable of improving the mixing of light generated by light-emitting chips and the dissipation of heat generated by light-emitting chips.

The present invention also provides a liquid crystal display ("LCD") having a light-emitting device which is capable of improving the mixing of light generated by light-emitting chips and the dissipation of heat generated by light-emitting chips.

According to exemplary embodiments of the present invention, there is provided a light-emitting device according to claim 1.

According to still other exemplary embodiments of the present invention, there is provided an LCD according to claim 14.

### BRIEF DESCRIPTION OF THE DRAWINGS

The above and other features and advantages of the present invention will become apparent by describing in detail exemplary embodiments thereof with reference to the attached drawings in which:
FIG. 1 illustrates an exploded perspective view of an exemplary liquid crystal display ("LCD");
FIG. 2 illustrates a plan view of an exemplary light-emitting device included in the exemplary LCD illustrated in FIG. 1;
FIG. 3 illustrates a plan view of an exemplary point light source of the exemplary light-emitting device illustrated in FIG. 2;
FIG. 4 illustrates a cross-sectional view taken along line IV-IV' of FIG. 3;
FIG. 5 illustrates a cross-sectional view of an embodiment, which is a variation of FIG. 4;
FIG. 6 illustrates a plan view of an exemplary light-emitting device according to an exemplary embodiment of the present invention;
FIG. 7 illustrates a plan view of an exemplary light-emitting device according to an exemplary embodiment of the present invention;
FIG. 8 illustrates a plan view of an exemplary light-emitting device according to an exemplary embodiment of the present invention; and
FIGS. 9A through 9D illustrate cross-sectional views for describing an exemplary method of manufacturing an exemplary light-emitting device according to an exemplary embodiment of the present invention.

### DETAILED DESCRIPTION OF THE INVENTION

The present invention will now be described more fully with reference to the accompanying drawings, in which exemplary embodiments of the invention are shown.

The invention may, however, be embodied in many different forms and should not be construed as being limited to the embodiments set forth herein; rather, these embodiments are provided so that this disclosure will be thorough and complete, and will fully convey the concept of the invention to those skilled in the art. Like reference numerals in the drawings denote like elements, and thus their description will be omitted.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

Hereinafter, the present invention will be described in detail with reference to the accompanying drawings.

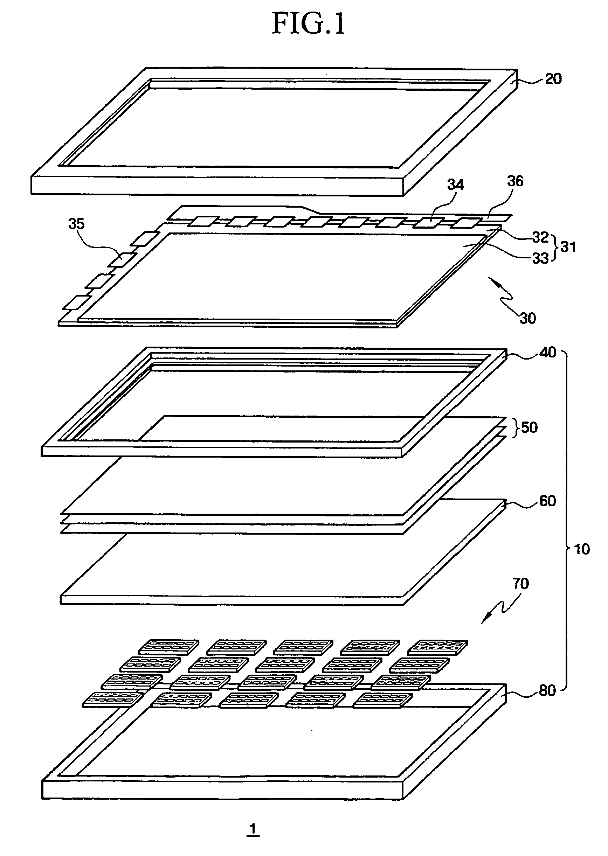

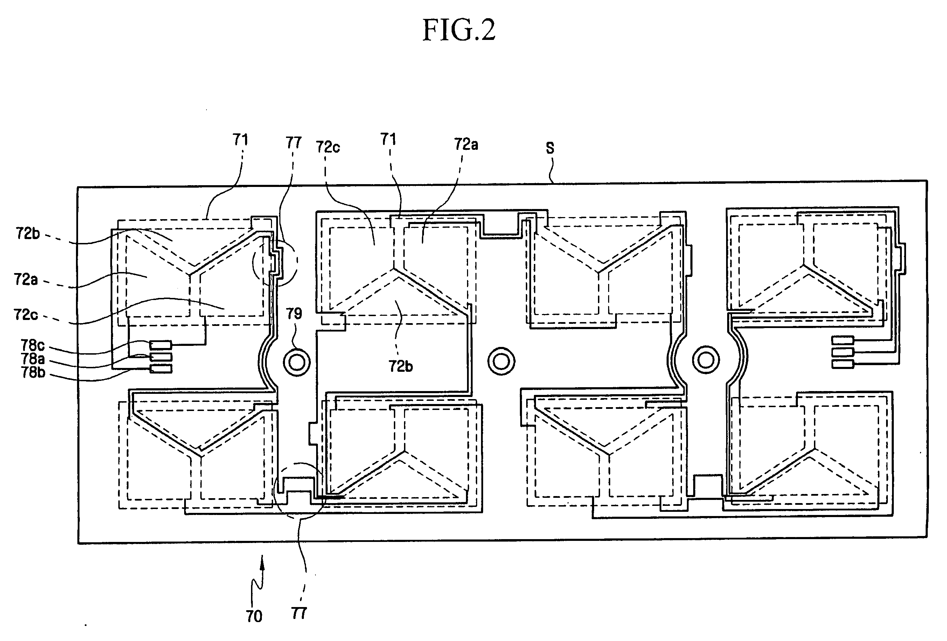

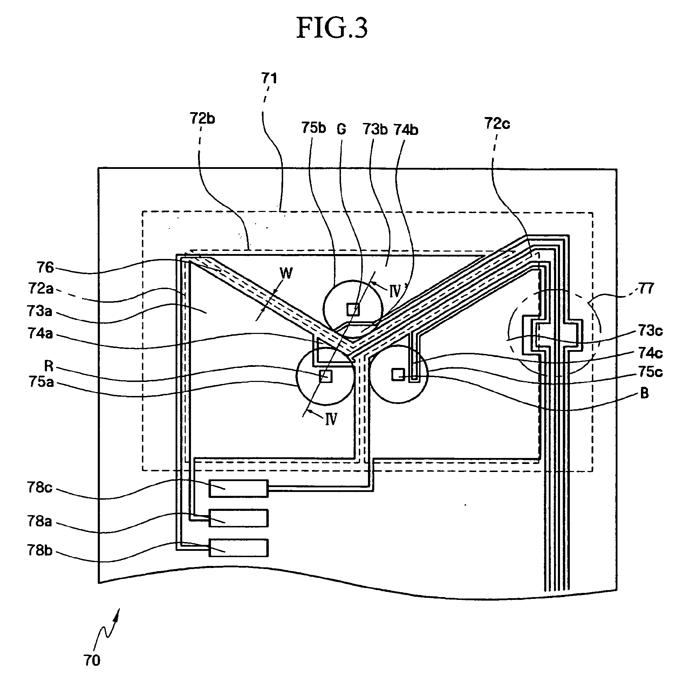

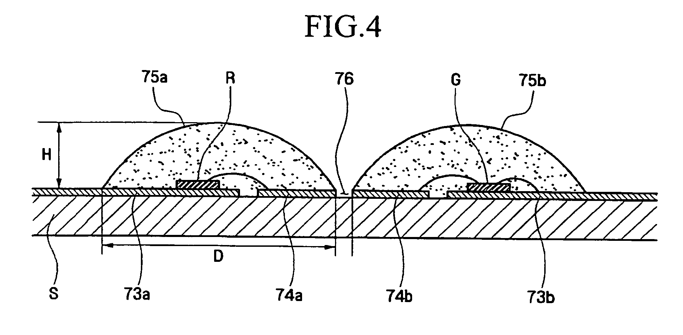

A liquid crystal display ("LCD") will hereinafter be described in detail with reference to FIGS. 1 through 4. FIG. 1 illustrates an exploded perspective view of an LCD 1, FIG. 2 illustrates a plan view of a light-emitting device 70 included in the LCD 1, FIG. 3 illustrates a plan view of an exemplary point light source of the light-emitting device 70, and FIG. 4 illustrates a cross-sectional view taken along line IV-IV' of FIG. 3.

Referring to FIG. 1, the LCD 1 includes a liquid crystal panel assembly 30, an upper container 20 and a backlight assembly 10.

The liquid crystal panel assembly 30 includes a liquid crystal panel 31, a plurality of gate tape carrier packages ("TCPs") 35, a plurality of data TCPs 34, and an integrated printed circuit board ("PCB") 36. The liquid crystal panel 31 includes a thin film transistor ("TFT") display panel 32, a common electrode display panel 33 and a liquid crystal layer (not shown) interposed between the TFT display panel 32 and the common electrode display panel 33.

The TFT display panel 32 includes a plurality of gate lines (not shown), a plurality of data lines (not shown), a TFT array, and a plurality of pixel electrodes. The common electrode display panel 33 includes a plurality of black matrices and a common electrode and faces the TFT display panel 32. The liquid crystal panel 31 displays image data.

The gate TCPs 35 are connected to the gate lines on the TFT display panel 32, and the data TCPs 34 are connected to the data lines on the TFT display panel 32.

A number of driving elements for processing a gate driving signal and a data driving signal are mounted on the PCB 36. The gate driving signal is applied to the gate TCPs 35, and the data driving signal is applied to the data TCPs 34. The PCB 36 is connected to the liquid crystal panel 31 and provides image data to the liquid crystal panel 31.

The upper container 20 forms an exterior of the LCD 1. The upper container 20 has an empty space therein, and can thus accommodate the liquid crystal panel assembly 30 therein. An open window is formed in a central region of the upper container 20 and exposes the liquid crystal panel 31.

The upper container 20 is coupled to a lower container 80 with a middle frame 40 interposed therebetween.

The backlight assembly 10 includes the middle frame 40, a plurality of optical sheets 50, a diffusion plate 60, the light-emitting device 70 and the lower container 80.

The middle frame 40 accommodates the optical sheets 50, the diffusion plate 60 and the light-emitting device 70 therein and is disposed in and fixed to the lower container 80. The middle frame 40 includes a plurality of sidewalls that form the outline of a rectangle. An open window is formed in the central region of the middle frame 40 so that light can transmit not only through the diffusion plate 60, the optical sheets 50 but also through the middle frame 40.

The optical sheets 50 diffuse and collect light transmitted by the diffusion plate 60. The optical sheets 50 are disposed on the diffusion plate 60 and are contained in the middle frame 40. The optical sheets 50 may include first and second prism sheets and a protective sheet.

The first and second prism sheets refract light passing through the diffusion plate 60, and can thus focus light incident thereupon at low angles, thereby improving the brightness of the LCD 1 within a valid viewing angle range. Two prism sheets may be used to refract light incident from various directions (e.g., vertical and horizontal directions) and thus to maximize the focus of light. However, only one prism sheet may be used if it is sufficient to focus light.

The protective sheet is disposed on the first and second prism sheets and protects the first and second prism sheets. Also, the protective sheet may further diffuse light, thereby providing a uniform distribution of light. While a particular number and arrangement of optical sheets 50 has been described, the structure of the optical sheets 50 is not restricted to that set forth herein. Rather, the structure of the optical sheets 50 may vary from one LCD to another.

The diffusion plate 60 diffuses light emitted from the light-emitting device 70 in various directions. The diffusion plate 60 prevents spots, which are bright areas that appear around point light sources, i.e., light-emitting diodes ("LEDs"), from being visible from the front of the LCD 1.

The light-emitting device 70 provides light to the liquid crystal panel 31. The light-emitting device 70 is disposed below the diffusion plate 60, and is contained in the middle frame 40 and the lower container 80.

Specifically, referring to FIGS. 2 through 4, the light-emitting device 70 includes an insulation substrate S, a plurality of cathode patterns 73a, 73b and 73c, a plurality of anode patterns 74a, 74b, and 74c, a plurality of light-emitting chips R, G, and B and a plurality of passivations 75a, 75b, and 75c.

The light-emitting device 70 is disposed below the diffusion plate 60. The number of point light sources mounted within the backlight assembly 10 may vary according to the size of the liquid crystal panel 31. The light-emitting device 70 may be formed as one body and have the same size as the liquid crystal panel 31. Alternatively, the light-emitting device 70 may be divided into a plurality of tiles. The light-emitting device 70 may be divided into a plurality of units, each including a point light source.

The light-emitting device 70 includes a plurality of point light sources that are mounted on the insulation substrate S, generates light with the aid of the point light sources, and supplies the light to the liquid crystal panel 31. A plurality of light source regions 71 1 are defined on the insulation substrate S, such that the light-emitting device 70 includes a plurality of light source regions 71. Each of the light source regions 71 includes one or more light-emitting chips R, G, and B and forms a point light source that emits white light. Each of the light source regions 71 also includes a plurality of sub-light source regions 72a, 72b, and 72c. The sub-light source regions 72a, 72b and 72c of each of the light source regions 71 include light-emitting chips R, G and B, respectively. The light-emitting chips R, G and B emit red light, green light and blue light, respectively. White light may be generated by mixing red light, green light and blue light. The light-emitting chips R, G and B may form a point light source. The light source regions 71 are defined on the insulation substrate S. The number of light source regions 71 may be determined according to the size of the liquid crystal panel 31. The number of sub-light source regions 72a, 72b and 72c of each of the light source regions 71 may be determined according to the number of light-emitting chips included in one light source region 71. The light-emitting chips R, G and B of each of the light source regions 71 may be disposed in the vicinity of one another. The light-emitting chips R, G and B of each of the light source regions 71 may be a predetermined distance apart from a predetermined point. That is, the light-emitting chips R, G, and B within a light source region 71 may be equally or substantially equally spaced from a same point within the light source region 71.

The light-emitting device 70 of the LCD 1 may include a plurality of rectangular light source regions 71, and each of the rectangular light source regions 71 may include three sub-light source regions 72a, 72b and 72c.

Referring to FIG. 3, sub-light source regions 72a, 72b and 72c of a light source region 71 include light-emitting chips R, G and B, respectively, cathode patterns 73a, 73b and 73c, respectively, anode patterns 74a, 74b and 74c, respectively, and passivations 75a, 75b and 75c, respectively. The light-emitting chips R, G and B may be red, green and blue light-emitting diodes ("LEDs"). The light-emitting chips R, G and B may be wire-bonded to the cathode patterns 73a, 73b and 73c, respectively, and to the anode patterns 74a, 74b and 74c, respectively, so that sufficient power to generate light can be supplied to the light-emitting chips R, G and B. First terminals of the light-emitting chips R, G and B may be wire-bonded to the anode patterns 74a, 74b and 74c, respectively, and second terminals of the light-emitting chips R, G and B may be connected to the cathode patterns 73a, 73b and 73c, respectively, using a conductive adhesive. Alternatively, the first terminals of the light-emitting chips R, G and B may be connected to the anode patterns 74a, 74b and 74c, respectively, using a conductive adhesive, and the second terminals of the light-emitting chips R, G and B may be wire-bonded to the cathode patterns 73a, 73b and 73c, respectively. Still alternatively, the first terminals of the light-emitting chips R, G and B may be wire-bonded to the anode patterns 74a, 74b and 74c, respectively, and the second terminals of the light-emitting chips R, G and B may also be wire-bonded to the cathode patterns 73a, 73b and 73c, respectively.

Referring to FIG. 2, the sub-light source regions 72a, 72b and 72c of each of the light source regions 71 include cathode patterns 73a, 73b and 73c, respectively, and anode patterns 74a, 74b and 74c, respectively, which supply power to light-emitting chips R, G and B. Cathode patterns 73a, 73b, and 73c in one light-source region 71 may be connected in series or in parallel to cathode patterns 73a, 73b, and 73c in another light-source region 71 adjacent thereto. Likewise, anode patterns 74a, 74b and 74c in one light-source region 71 may be connected in series or in parallel to anode patterns 74a, 74b and 74c in a light-source region 71 adjacent thereto. Cathode patterns 73a, 73b, and 73c are insulated from corresponding sub-light source regions 72a, 72b and 72c. Likewise, anode patterns 74a, 74b, and 74c are also insulated from corresponding sub-light source regions 72a, 72b and 72c.

Referring to FIG. 3, the light-emitting chips R, G and B may be disposed on the cathode patterns 73a, 73b and 73c, respectively, or on the anode patterns 74a, 74b and 74c, respectively. The cathode patterns 73a, 73b and 73c and the anode patterns 74a, 74b and 74c may be formed of a material having excellent electric conductivity. Specifically, the cathode patterns 73a, 73b and 73c and the anode patterns 74a, 74b and 74c may be formed of a material having excellent electric and thermal conductivity such as, but not limited to, copper (Cu). Then, the cathode patterns 73a, 73b and 73c and the anode patterns 74a, 74b and 74c may serve as heat dissipation patterns that dissipate heat generated by the light-emitting chips R, G and B. That is, the cathode patterns 73a, 73b and 73c or the anode patterns 74a, 74b and 74c may be attached onto the light-emitting chips R, G and B using an adhesive having excellent thermal conductivity. Then, heat generated by the light-emitting chips R, G and B may be transmitted to the cathode patterns 73a, 73b and 73c or the anode patterns 74a, 74b and 74c. In order to increase the heat dissipation efficiency of the cathode patterns 73a, 73b and 73c and the anode patterns 74a, 74b and 74c, the cathode patterns 73a, 73b and 73c or the anode patterns 74a, 74b and 74c may be formed to range over a wide area.

Specifically, in order to maximize the efficiency of the dissipation of heat generated by the light-emitting chips R, G and B, the cathode patterns 73a, 73b and 73c or the anode patterns 74a, 74b and 74c may be formed in the sub-light source regions 72a, 72b and 72c, respectively, to range over as wide an area as possible. In other words, the pattern, whether it be the cathode pattern 73a, 73b, 73c or the anode pattern 74a, 74b, 74c on which the light-emitting chips R, G, and B are disposed, may extend over substantially an entire area of a respective sub-light source region, with the exception of where the other cathode or anode pattern extends and an interposing spacing therebetween. In the illustrated example, the cathode patterns 73a, 73b, and 73c are used as heat dissipation patterns and are connected to pads 78a, 78b, 78c, respectively. The driving voltage is applied to the cathode pattern 73a, 73b, 73c via the pads 78a, 78b, 78c. The pads 78a, 78b, 78c are disposed the outside of the light source regions 71 and assembled on a side of the insulation substrate S to be easily connected to the power supply module(not shown). The power supply module may be connected to the pads 78a, 78b, 78c by a connector(not shown) or a solder material.
The light-emitting device 70 may be fixed to the lower container 80 via holes 79. Screws and rivets may be inserted in the holes 79, and combine the light-emitting device 70 with the lower container 80. Besides, the light-emitting device 70 may be combined with the lower container 80 by an adhesive tape.
The light-emitting device 70 may use the cathode patterns 73a, 73b and 73c and the anode patterns 74a, 74b and 74c as heat dissipation patterns . That is, a plurality of heat dissipation patterns may be respectively formed in the sub-light source regions 72a, 72b and 72c to range over as wide an area as possible, and then, the cathode patterns 73a, 73b and 73c and the anode patterns 74a, 74b and 74c may be disposed in the vicinity of the heat dissipation patterns.

Most parts of the sub-light source regions 72a, 72b and 72c are occupied by the cathode patterns 73a, 73b, and 73c and the anode patterns 74a, 74b, and 74c. The sub-light source regions 72a, 72b and 72c having the light-emitting chips R, G and B, respectively, include the cathode patterns 73a, 73b, and 73c, respectively, and the anode patterns 74a, 74b, and 74c, respectively. The cathode patterns 73a, 73b and 73c and the anode patterns 74a, 74b, and 74c may be arranged radially with respect to a predetermined point. That is, the cathode patterns 73a, 73b and 73c or the anode patterns 74a, 74b, and 74c may be defined by dividing, for example, a rectangle, into three portions having a center angle of about 120°. The cathode patterns 73a, 73b and 73c or the anode patterns 74a, 74b, and 74c may form a rectangle, thereby maximizing the area of the cathode patterns 73a, 73b and 73c or the anode patterns 74a, 74b, and 74c combined. The light-emitting chips R, G and B may be connected in series to one another. In this manner, it is possible to reduce deviations among the light-emitting chips R, G and B. The light-emitting chips R, G, and B may be substantially equally spaced from each other and substantially equally spaced from a central point between the light-emitting chips R, G, and B. The light-emitting chips R, G, and B may be arranged as points in an equilateral triangle. Alternatively, the light-emitting chips R, G and B may be spaced apart from each other and spaced from a predetermined point such that white light may be effectively obtained by mixing of the lights therefrom. If there are a considerable number of light-emitting chips provided, a number of light source strings may be provided. The light source strings may be connected in parallel to one another. Interconnections that connect the cathode patterns 73a, 73b and 73c and the anode patterns 74a, 74b, and 74c may be formed as interconnection patterns during the formation of the cathode patterns 73a, 73b and 73c and the anode patterns 74a, 74b, and 74c. In order to reduce deviations in the resistances of the interconnections, a resistance-adjustment module 77 may be provided. The resistance-adjustment module 77 may arbitrarily adjust the lengths of the interconnections in consideration of deviations in the resistances of the interconnections. Alternatively, the resistance-adjustment module 77 may arbitrarily adjust the widths of the interconnections in consideration of deviations in the resistances of the interconnections.

The passivations 75a, 75b, and 75c are formed on the light-emitting chips R, G and B, respectively, independently of one another. The passivations 75a, 75b, and 75c may be formed as domes, as illustrated in FIG. 4, and may thus serve as lenses. The passivations 75a, 75b, and 75c may be formed from a transparent liquid material having a viscous property such as silicon or epoxy that may harden upon drying. The passivations 75a, 75b, and 75c may be formed not to overlap one another. Since the passivations 75a, 75b, and 75c are formed from a liquid, the passivations 75a, 75b, and 75c are highly likely to overlap each other, and thus, a height H of the passivations 75a, 75b, and 75c may decrease due to surface tension. As a result, the passivations 75a, 75b, and 75c may not be able to be formed as domes and thus to serve as lenses. As the height H decreases, the amount of light emitted by the light-emitting chips R, G and B, and then totally-reflected by the passivations 75a, 75b, and 75c gradually decreases. The height H may be half the diameter D of the passivations 75a, 75b, and 75c.

Gaps 76 are disposed between the sub-light source regions 72a, 72b, and 72c. The gaps 76 isolate the passivations 75a, 75b, and 75c from one another. That is, the passivations 75a, 75b, and 75c are placed in contact with the gaps 76 and can thus be separated from one another by the gaps 76. The cathode patterns 73a, 73b, and 73c and the anode patterns 74a, 74b, and 74c are formed on the insulation substrate S to a predetermined thickness. The step difference between the insulation substrate S and the cathode patterns 73a, 73b, and 73c or the step difference between the insulation substrate S and the anode patterns 74a, 74b, and 74c causes surface tension in the passivations 75a, 75b, and 75c, and can thus maintain the passivations 75a, 75b, and 75c in the shape of a dome. Each of the gaps 76 may be defined as the space between a pair of adjacent cathode patterns or between a pair of adjacent anode patterns. That is, the gaps 76 may correspond to the spaces among the cathode patterns 73a, 73b, and 73c or the spaces among the anode patterns 74a, 74b, and 74c.

The gaps 76 may be formed in various manners as long as they can cause surface tension to the passivations 75a, 75b, and 75c and maintain the passivations 75a, 75b, and 75c in the shape of a dome. Thus, the passivations 75a, 75b, 75c are separated from each other by a width of the gap 76. The width W of the gaps 76 may be about 0.05 to about 1 mm.

A reflective material is applied onto the entire surface of the insulation substrate S, excluding portions where the light-emitting chips are mounted, thereby forming a reflective layer (not shown). The reflective layer increases the light emission efficiency of the light-emitting chips R, G and B.

The light-emitting device 70 may be contained in the lower container 80, and the lower container 80 may be coupled to the middle frame 40 and the upper container 20.

A power supply module (not shown) may be provided below the lower container 80. The power supply module converts power supplied thereto from an external source and thus supplies a driving voltage to light sources. If the LCD 1 uses LEDs as light sources, the power supply module may be a direct current-to-direct current ("DC/DC") converter.

Once the power supply module is disposed on the bottom of the lower container 80, the lower container 80 may be covered with a cover (not shown) so that the power supply module can be isolated and protected against external impact.

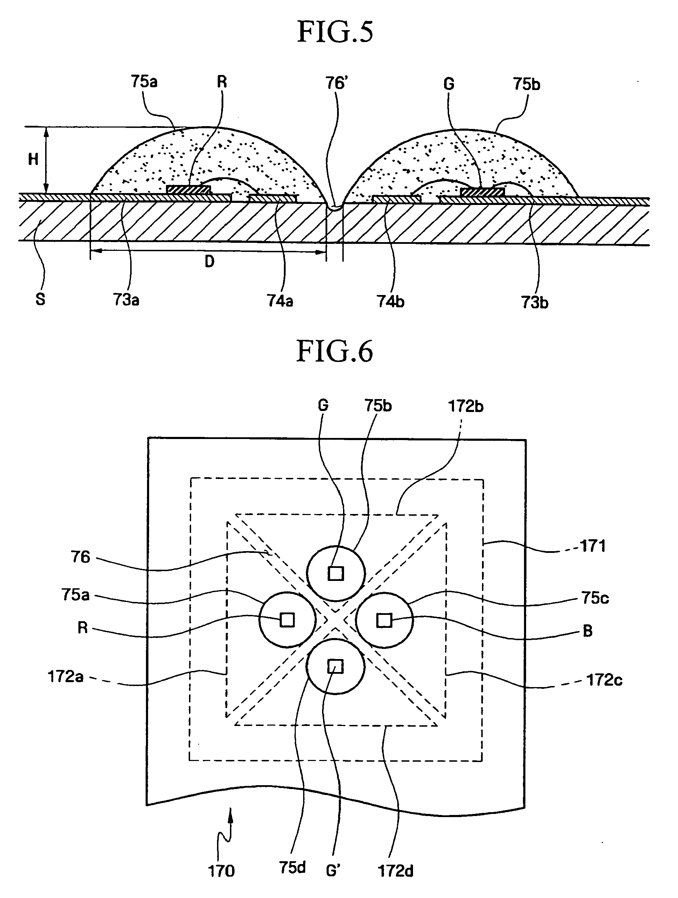

A variation of the example of FIGS. 1 through 4 will hereinafter be described in detail with reference to FIG. 5.

FIG. 5 illustrates a cross-sectional view of an embodiment, which is a variation of FIG. 4. Referring to FIG. 5, a gap 76' is recessed into an insulation substrate S as a recess. Specifically, the gap 76' may be formed at a depth substantially the same as the difference between cathode patterns 73a and 73b and the insulation substrate S or the difference between anode patterns 74a and 74b and the insulation substrate S, but the present invention is not restricted to this. That is, a recess of varying depths may be formed on the insulation substrate S as the gap 76'.

The gap 76' may be formed using a mechanical processing method. The gap 76' may be formed along the space between passivations 75a and 75b and have a cross-sectional shape of an arc. The gap 76' may be formed separately regardless of the shapes of the cathode patterns 73a and 73b and the anode patterns 74a and 74b. In this manner, it is possible to freely determine the thickness or depth of the gap 76'.

The gap 76' may be formed as a trench by using the cathode patterns 73a and 73b and the anode patterns 74a and 74b. That is, if the cathode patterns 73a and 73b and the anode patterns 74a and 74b are thin, a recess may be formed on the insulation substrate S as the gap 76' so that the passivations 75a and 75b can be maintained in the shape of a dome.

LCDs according to other exemplary embodiments of the present invention will hereinafter be described in detail on the assumption that the LCDs have gaps 76. However, the present invention is applied to LCDs having gaps 76'. That is, the following exemplary embodiments include the gaps 76'.

An LCD according to another exemplary embodiment of the present invention will hereinafter be described in detail with reference to FIG. 6.

FIG. 6 illustrates a plan view of an exemplary point light source of an exemplary light-emitting device 170 according to another exemplary embodiment of the present invention. Referring to FIG. 6, a light source region 171 of a light-emitting device 170 includes four light-emitting chips R, G, G' and B. If the point light source is a light source that generates white light by mixing red light, green light and blue light, three or more light-emitting chips may be formed in the light source region 171.

The light source region 171 includes four sub-light source regions 172a, 172b, 172c and 172d. The sub-light source regions 172a, 172b, 172c and 172d include the light-emitting chips R, G, G' and B, respectively. Gaps 76 are disposed among the light-emitting chips R, G, G' and B. The gaps 76 are formed diagonally in the light source region 171. That is, the light source region 171 may be formed as a rectangle, and the sub-light source regions 172a, 172b, 172c and 172d may be formed as triangles obtained by dividing a rectangle diagonally. The light-emitting chips R, G, G' and B may be formed in the sub-light source regions 172a, 172b, 172c and 172d, respectively, and may form substantially equally spaced from each other to form points of a square and substantially equally spaced from a central point therebetween. Alternatively, the light-emitting chips R, G, G' and B may be spaced apart from each other and spaced from a predetermined point such that white light may be effectively obtained by mixing of the lights therefrom. Passivations 75a, 75b, 75c, and 75d are respectively formed on the light-emitting chips R, G, G' and B, respectively. Gaps 76 are formed among the passivations 75a, 75b, 75c, and 75d. The passivations 75a, 75b, 75c, and 75d may be maintained in the shape of a dome due to surface tension. The passivations 75a, 75b, 75c, and 75d are arranged radially with respect to a predetermined point that is a central point of the square formed by the light-emitting chips R, G, G' and B. The light source region 171 may be formed as a rectangle, thereby maximizing the area of the sub-light source regions 172a, 172b, 172c and 172d combined. Most parts of the sub-light source regions 172a, 172b, 172c and 172d are occupied by cathode patterns and anode patterns, such as previously described in the prior exemplary embodiments. However, in the exemplary embodiment including four sub-light source regions, a combined area of the cathode pattern and anode pattern for each respective sub-light source region may take the shape of a triangle.

The number of sub-light source regions included in the light source region 171 may be determined according to the number of light-emitting chips. That is, more than four or less than four sub-light source regions may be provided.

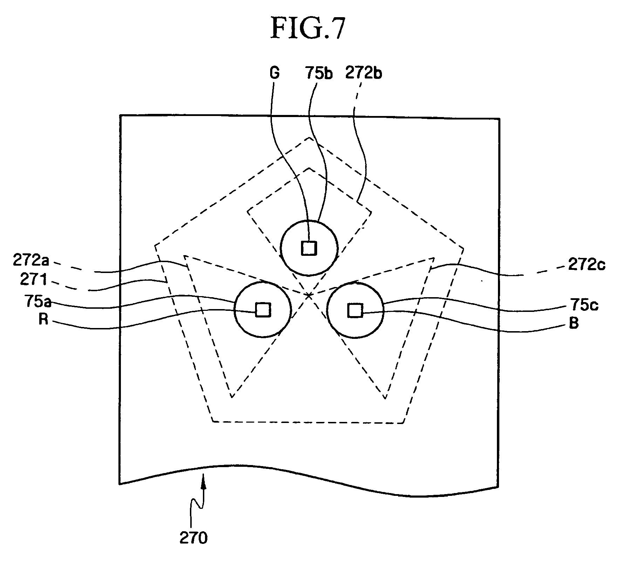

An LCD according to another exemplary embodiment of the present invention will hereinafter be described in detail with reference to FIG. 7.

FIG. 7 illustrates a plan view of an exemplary point light source of an exemplary light-emitting device 270 according to another exemplary embodiment of the present invention. Referring to FIG. 7, a light source region 271 of the light-emitting device 270 is formed as a pentagon. The angle of gaps may be adjusted in order to alter the diameter of passivations 75a, 75b and 75c, which respectively cover light-emitting chips R, G and B.

A light source region 271 is defined on an insulation substrate S, and a plurality of sub-light source regions 272a, 272b and 272c are formed in the light source region 271. The sub-light source regions 272a, 272b and 272c may be a predetermined distance apart from their respective neighboring sub-light source regions 272a, 272b and 272c in order to effectively dissipate heat generated by the light-emitting chips R, G and B. That is, the light source region 271 may be formed as a pentagon, thereby sufficiently increasing the area of cathode patterns and anode patterns combined while securing the distance between the sub-light source regions 272a, 272b and 272c and their respective neighboring sub-light source regions 272a, 272b and 272c. The sub-light source regions 272a, 272b and 272c may be formed in various shapes and sizes.

The light-emitting chips R, G and B are a predetermined distance apart from a predetermined point, and are in the vicinity of one another so that light generated by the light-emitting chips R, G and B can be easily mixed. The shape and the area of the sub-light source regions 272a, 272b and 272c may be altered according to the area and the heat dissipation properties of the light source region 271. That is, the light source region 271 may be increased so that the influence of an adjacent light source can be minimized.

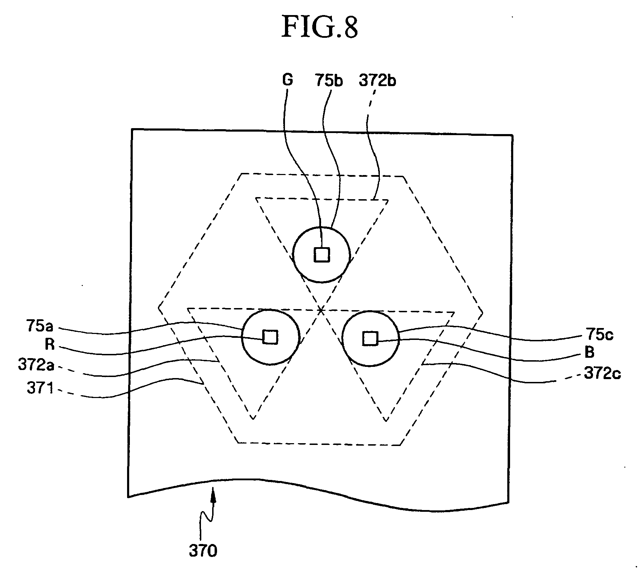

An LCD according to another exemplary embodiment of the present invention will hereinafter be described in detail with reference to FIG. 8.

FIG. 8 illustrates a plan view of an exemplary point light source of an exemplary light-emitting device 370 according to another exemplary embodiment of the present invention. Referring to FIG. 8, a light source region 371 of the light-emitting device 370 is formed as a hexagon. In order to dispose three light-emitting chips R, G and B in the light source region 371, three sub-light source regions 372a, 372b, and 372c may be formed in the light source region 371 as triangles.

Specifically, the light source region 371 includes the sub-light source regions 372a, 372b, and 372c which are triangular. The light-emitting chips R, G and B may be disposed in the sub-light source regions 372a, 372b, and 372c, respectively. The light-emitting chips R, G and B may be a predetermined distance apart from one another so that they can form an imaginary triangle together. The imaginary triangle may be an equilateral triangle. In short, in the exemplary embodiment of FIG. 8, the light source region 371 is formed as a hexagon, and thus, the sub-light source regions 372a, 372b, and 372c may be formed in the light source region 371 to have the same area and may be sufficiently distanced apart from one another to dissipate heat generated by the light-emitting chips R, G and B.

In FIGS. 1 through 8, a light source region may be formed as a rectangle, a polygon or a hexagon. However, the present invention is not restricted to this. That is, a light source region and a plurality of sub-light source regions of the light source region may be formed in various shapes as long as they can allow a plurality of light emitting chips to be a predetermined distance apart from a predetermined point and to be arranged radially with respect to the predetermined point, can maximize the efficiency of the dissipation of heat, can allow gaps to be formed among the light-emitting chips and can allow a plurality of passivations to be formed on the respective light-emitting chips independently of one another.

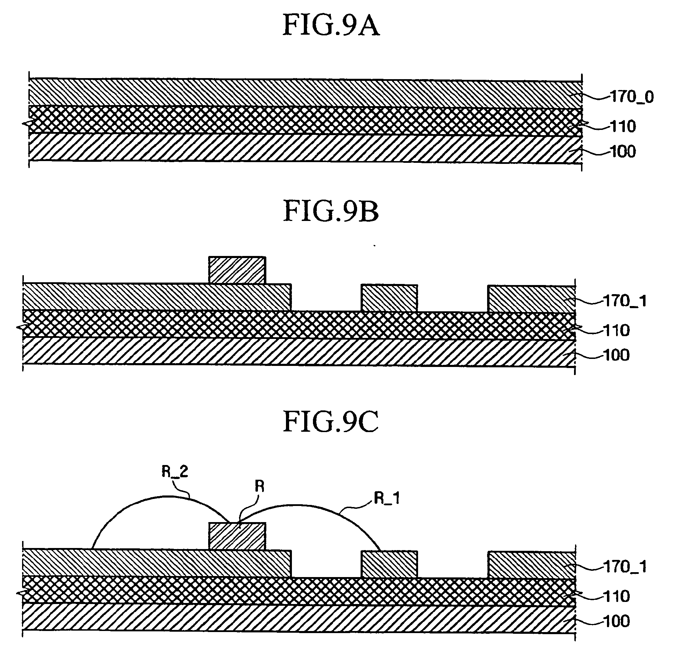

An exemplary method of manufacturing an exemplary light-emitting device will hereinafter be described in detail with reference to FIGS. 9A through 9D.

FIGS. 9A through 9D illustrate cross-sectional views for describing an exemplary method of manufacturing an exemplary light-emitting device.

Referring to FIG. 9A, a prepreg layer 110 is deposited on at least one surface of a metal core layer 100.

Specifically, the metal core layer 100 may be formed of a metal that has excellent thermal and electric conductivity and can be easily converted into black oxide. For example, the metal core layer 100 may be formed of aluminum or copper. The prepreg layer 110 may be deposited on the metal core layer 100. Prepreg is a material prepared by impregnating a reinforced fiber material such as fabric or mats with a thermosetting resin. A polyester resin, an epoxy resin, a diarylphthalate resin, a phenol resin, or a melamine resin may be used as the thermosetting resin.

A metal film 170_0 is formed on the prepreg layer 110. The metal film 170_0 may be formed of any conductive metal, and, more particularly, may be formed of copper. The metal film 170_0 may be formed using a hot press method.

Thereafter, referring to FIG. 9B, electrode patterns 170_1 are formed by patterning the metal film 170_0 such as by using an etching method. The electrode patterns 170_1 may be formed in various shapes to provide the anode and cathode patterns.

Thereafter, referring to FIG. 9C, a light-emitting chip R may be mounted on an electrode pattern 170_1 using a soldering method or a wire bonding method. Specifically, the light-emitting chip R may be soldered on an electrode pattern 170_1. Alternatively, the light-emitting chip R may be electrically connected to an electrode pattern 170_1 and an adjacent electrode pattern 170_1 using electrode wires R1 and R2.

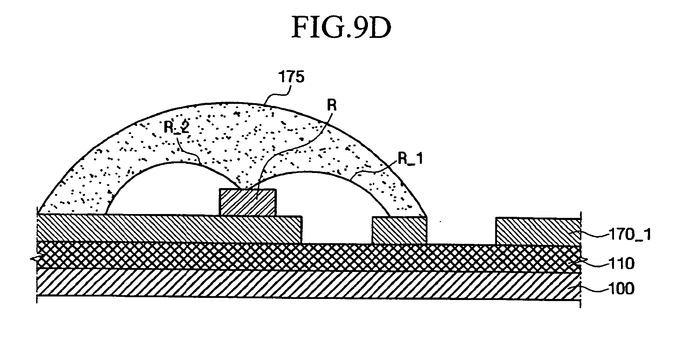

Thereafter, referring to FIG. 9D, a film 175 is formed on the light-emitting chip R and covers the light-emitting chip R. The film 175 may be formed by dropping a liquid material on the light-emitting chip R using a dispensing method. The film 175 may be formed in the shape of a lens due to its viscosity and surface tension. A gap between an electrode pattern 170_1 to which the light-emitting chip R is connected and an adjacent electrode pattern 170_1 assists the film 175 in forming the dome shape.

As described above, according to the present invention, it is possible to improve the mixing of light generated by light-emitting chips and the dissipation of heat generated by light-emitting chips.

While the present invention has been particularly shown and described with reference to exemplary embodiments thereof, it will be understood by those of ordinary skill in the art that various changes may be made in form and details may be made without departing from the scope of the present invention as defined by the following claims.

## Claims

1. A light-emitting device (70; 170; 270; 370) comprising:
a substrate (S) on which at least one light source region (71; 171; 271; 371) is defined, the light source region (71; 171; 271; 371) comprising sub-light source regions (72a, 72b, 72c; 172a, 172b, 172c, 172d; 272a, 272b, 272c; 372a, 372b, 372c) that are separated from one another by a gap (76: 76');
a plurality of electrode patterns which are respectively formed in the sub-light source regions (72a, 72b, 72c; 172a, 172b, 172c, 172d; 272a, 272b, 272c; 372a, 372b, 372c);
a plurality of light-emitting chips (R; G; G', B) which are respectively connected to the electrode patterns; and
a plurality of passivations (75a, 75b, 75c, 75d) which respectively cover the light-emitting chips (R; G; G', B),
wherein the passivations (75a, 75b, 75c, 75d) are separated from each other by the gap (76; 76') **characterised in that** the gap (76') comprises a trench which is formed in the substrate (S) and between the sub-light source regions (72a, 72b, 72c),
and **in that**
the gap (76') extends radially from a predetermined point.

2. The light-emitting device (70; 170; 270; 370) of claim 1, wherein an electrode pattern upon which a light-emitting chip (R; G; G', B) is formed is disposed in a majority of an area of its respective sub-light source region (72a, 72b, 72c; 172a, 172b, 172c, 17Zd; 272a, Z72b, 272c; 372a, 372b, 372c).

3. The light-emitting device (70; 170; 270; 370) of claim 1, wherein the electrode patterns are respectively disposed under the light-emitting chips (R; G; G', B).

4. The light-emitting device (70; 170; 270; 370) of claim 1, wherein the electrode patterns comprise a cathode pattern (73a, 73b, 73c) and an anode pattern (74a, 74b, 74c).

5. The light-emitting device (70; 170; 270; 370) of claim 1, wherein the electrode patterns are formed radially with respect to a predetermined point.

6. The light-emitting device (70; 170; 270; 370) of claim 5, wherein the light source region (71; 171; 271; 371) is polygonal, and the electrode patterns are divided radially with respect to the predetermined point.

7. The light-emitting device (70; 174; 270; 370) of claim 1, wherein the gap (76; 76') is defined by the electrode patterns which are a predetermined distance apart from each other.

8. The light-emitting device (70; 170; 270; 370) of claim 1, wherein the light source region (71; 171; 271; 371) comprises at least three sub-light source regions (72a, 72b, 72c; 172a, 172b, 172c, 172d; 272a, 272b, 272c; 372a, 372b, 372c).

9. The light-emitting device (70; 170; 270; 370) of claim 1, wherein the light-emitting chips (R; G; G', B) are disposed in vicinity of each other with the gap (76; 76') interposed therebetween.

10. The light-emitting device (70; 170; 270; 370) of claim 1, wherein the passivations (75a, 75b, 75c, 75d) are formed as domes.

11. The light-emitting device (70; 170; 270; 370) of claim 1, wherein the passivations (75a, 75b, 75c, 75d) are placed in contact with the gap (76; 76').

12. The light-emitting device (70; 170; 270; 370) of claim 1, further comprising a reflective layer which is formed on substantially an entire surface of the substrate (S), excluding portions where the light-ermitting chips (R; G; G', B) are disposed.

13. The light-emitting device (70) of claim 1, wherein the electrode patterns form a light source string by being connected in series to one or more electrode patterns in an adjacent light source region (71) through a resistance-adjustment module (77), the light source string being connected in parallel to other light source strings.

14. A liquid crystal display comprising:
a liquid crystal panel (31) for displaying an image; and
a light-emitting device (70; 170; 270; 370) according to one of the claims 1. 2, 3, 7, 9, 9, or 11, the light-emitting device (70; 170; 270; 370) for providing light to the liquid crystal panel (31).

## Patentansprüche

1. Lichtemittierende Vorrichtung (70; 170; 270; 370), die Folgendes umfasst:
ein Substrat (S), auf dem wenigstens ein Lichtquellenbereich (71; 171; 271; 371) begrenzt ist, wobei der Lichtquellenbereich (71; 171; 271; 371) Lichtquellen-Teilbereiche (72a, 72b, 72c; 172a, 172b, 172c, 172d; 272a, 272b, 272c; 372a, 372b, 372c) umfasst, die voneinander durch einen Spalt (76; 76') getrennt sind;
eine Mehrzahl von Elektrodenmustern, die jeweils in den Lichtquellen-Teilbereichen (72a, 72b, 72c; 172a, 172b, 172c, 172d; 272a, 272b, 272c; 372a, 372b, 372c) ausgebildet sind;
eine Mehrzahl lichtemittierender Chips (R; G; G', B), die jeweils mit den Elektrodenmustern verbunden sind; und
eine Mehrzahl von Passivierungen (75a, 75b, 75c, 75d), die jeweils die lichtemittierenden Chips (R; G; G', B) abdecken,
wobei die Passivierungen (75a, 75b, 75c, 75d) voneinander durch den Spalt (76; 76') getrennt sind,
**dadurch gekennzeichnet, dass** der Spalt (76') einen Einschnitt umfasst, der im Substrat (S) zwischen den Lichtquellen-Teilbereichen (72a, 72b, 72c) ausgebildet ist,
und dadurch, dass
sich der Spalt (76') radial von einem bestimmten Punkt aus erstreckt.

2. Lichtemittierende Vorrichtung (70; 170; 270; 370) gemäß Anspruch 1, wobei ein Elektrodenmuster, auf dem ein lichtemittierender Chip (R; G; G', B) ausgebildet ist, in einem Großteil einer Fläche ihres entsprechenden Lichtquellen-Teilbereichs (72a, 72b, 72c; 172a, 172b, 172c, 172d; 272a, 272b, 272c; 372a, 372b, 372c) angeordnet ist.

3. Lichtemittierende Vorrichtung (70; 170; 270; 370) gemäß Anspruch 1, wobei die Elektrodenmuster jeweils unter den lichtemittierenden Chips (R; G; G', B) angeordnet sind.

4. Lichtemittierende Vorrichtung (70; 170; 270; 370) gemäß Anspruch 1, wobei die Elektrodenmuster ein Kathodenmuster (73a; 73b, 73c) und ein Anodenmuster (74a, 74b, 74c) umfassen.

5. Lichtemittierende Vorrichtung (70; 170; 270; 370) gemäß Anspruch 1, wobei die Elektrodenmuster radial in Bezug auf einen bestimmten Punkt ausgebildet sind.

6. Lichtemittierende Vorrichtung (70; 170; 270; 370) gemäß Anspruch 5, wobei der Lichtquellenbereich (71; 171; 271; 371) polygonal ist und die Elektrodenmuster mit Bezug auf den bestimmten Punkt radial unterteilt sind.

7. Lichtemittierende Vorrichtung (70; 170; 270; 370) gemäß Anspruch 1, wobei der Spalt (76, 76') von den Elektrodenmustern begrenzt wird, die eine bestimmte Distanz voneinander entfernt angeordnet sind.

8. Lichtemittierende Vorrichtung (70; 170; 270; 370) gemäß Anspruch 1, wobei der der Lichtquellenbereich (71; 171; 271; 371) mindestens drei Lichtquellen-Teilbereiche (72a, 72b, 72c; 172a, 172b, 172c, 172d; 272a, 272b, 272c; 372a, 372b, 372c) umfasst.

9. Lichtemittierende Vorrichtung (70; 170; 270; 370) gemäß Anspruch 1, wobei die lichtemittierenden Chips (R; G; G', B) in der Nähe voneinander angeordnet sind und der Spalt (76, 76') dazwischen eingefügt ist

10. Lichtemittierende Vorrichtung (70; 170; 270; 370) gemäß Anspruch 1, wobei die Passivierungen (75a, 75b, 75c, 75d) als Kuppeln ausgeführt sind.

11. Lichtemittierende Vorrichtung (70; 170; 270; 370) gemäß Anspruch 1, wobei die Passivierungen (75a, 75b, 75c, 75d) in Kontakt mit dem Spalt (76, 76') angeordnet sind.

12. Lichtemittierende Vorrichtung (70; 170; 270; 370) gemäß Anspruch 1, die ferner eine reflektierende Schicht umfasst, die im wesentlichen auf einer gesamten Oberfläche des Substrats (S) ausgebildet ist, ausgenommen jene Teile, auf denen die lichtemittierenden Chips (R; G; G', B) angeordnet sind.

13. Lichtemittierende Vorrichtung (70; 170; 270; 370) gemäß Anspruch 1, wobei die Elektrodenmuster eine Lichtquellenkette bilden, indem sie über ein Widerstandeinstellungsmodul (77) in Serie mit einem oder mehreren Elektrodenmustern in einem angrenzenden Lichtquellenbereich (71) verbunden sind, wobei die Lichtquellenkette parallel zu anderen Lichtquellenketten geschaltet ist.

14. Flüssigkristall-Display, umfassend:
ein Flüssigkristallfeld (31) zum Anzeigen eines Bildes; und eine lichtemittierende Vorrichtung (70; 170; 270; 370) gemäß einem der Ansprüche 1, 2, 3, 7, 8, 9, oder 11, wobei die lichtemittierenden Vorrichtung (70; 170; 270; 370) dazu dient, das Flüssigkristallfeld (31) mit Licht zu versorgen.

## Revendications

1. Un dispositif émetteur de lumière (70 ; 120 ; 270 ; 370) comprenant :
un substrat (S) sur lequel au moins une des régions sources de lumière (71 ; 171 ; 271; 371) est définie, la région source de lumière (71 ; 171 ; 271; 371) comprenant des régions sources de sous-lumière (72a ; 72b ; 72c ; 172a; 172b ; 172c ; 172d ; 272a ; 272b ; 272c ; 372a ; 372b ; 372c) qui sont séparées l'une de l'autre par un espace (76 ; 76') ;
une pluralité de configurations d'électrodes qui sont respectivement formées dans les régions sources de lumière (72a ; 72b ; 72c ; 172a ; 172b ; 172c ; 172d ; 272a ; 272b ; 272c ; 372a ; 372b ; 372c) ;
une pluralité de puces émettrices de lumière (R ; G; G'; B) qui sont respectivement connectées aux configurations d"électrodes ; et
une pluralité de passivations (75a, 75b, 75c, 75d) qui couvrent respectivement les puces émettrices de lumière (R ; G ; G' ; B),
où les passivations (75a ; 75b ; 75c ; 75d) sont séparées l'une de l'autre par l'espace (76 ; 76'), **caractérisé en ce que** l'espace (76') comprend une tranchée qui est formée dans le substrat (S) et entre les régions sources de sous-lumière (72a, 72b, 72c),
et **en ce que**
l'espace (76") s'étend radialement à partir d'un point prédéterminé.

2. Le dispositif émetteur de lumière (70 ; 170 ; 270; 370) de la revendication 1, où une configuration d'électrode sur laquelle une puce émettrice de lumière (R; G ; G' ; B) est formée, est disposée dans une majorité d'une zone de sa région source de sous-lumière respective (72a; 72b ; 72c ; 172a ; 172b; 172c ; 172d ; 272a ; 272b ; 272c ; 372a ; 372b ; 372c).

3. Le dispositif émetteur de lumière (70 ; 170 ; 270 ; 370) de la revendication 1, où les configurations d'électrodes sont disposées respectivement sous les puces émettrices de lumière (R ; G ; G', B).

4. Le dispositif émetteur de lumière (70 ; 170 ; 270 ; 370) de la revendication 1, où les configurations d'électrodes comprennent une configuration de cathode (73a, 73b, 73c) et une configuration d'anode (74a, 74b, 74c).

5. Le dispositif émetteur de lumière (70 ; 170 ; 270 ; 370) de la revendication 1, où les configurations d'électrodes sont formées radialement par rapport à un point prédéterminé.

6. Le dispositif émetteur de lumière (70 ; 170 ; 270 ; 370) de la revendication 5, où la région source de lumière (71 ; 171 ; 271 ; 371) est polygonal, et les configurations d'électrodes sont radialement divisées par rapport au point prédéterminé.

7. Le dispositif émetteur de lumière (70 ; 170 ; 270 ; 370) de la revendication 1, où l'espace (76 ; 76') est défini par les configurations d'électrodes qui sont à une distance prédéterminée l'une de l'autre.

8. Le dispositif émetteur de lumière (70 ; 170 ; 270 ; 370) de la revendication 1, où la région source de lumière (71 ; 171 ; 271 ; 371) comprend au moins trois régions sources de sous-lumière (72a ; 72b ; 72c ; 172a ; 172b ; 172c ; 172d ; 272a ; 272b ; 272c ; 372a ; 372b ; 372c).

9. Le dispositif émetteur de lumière (70 ; 170 ; 270 ; 370) de la revendication 1, où les puces émettrices de lumière (R ; G ; G' ; B) sont disposées à proximité les unes des autres avec l'espace (76 ; 76') interposé entre elles.

10. Le dispositif émetteur de lumière (70 ; 170 ; 270 ; 370) de la revendication 1, où les passivations (75a, 75b, 75c,75d) sont formées comme des dômes.

11. Le dispositif émetteur de lumière (70 ; 170 ; 270 ; 370) de la revendication 1, où les passivations (75a, 75b, 75c, 75d) sont mises en contact avec l'espace (76 ; 76').

12. Le dispositif émetteur de lumière (70 ; 170 ; 270 ; 370) de la revendication 1, comprenant de plus une couche réflective qui est formée substantiellement sur une surface entière du substrat (S), excluant des portions où les puces émettrices de lumière (R ; G ; G' ; B) sont disposées.

13. Le dispositif émetteur de lumière (70 ; 170 ; 270 ; 370) de la revendication 1, où les configurations d'électrodes forment un fil source de lumière en étant connecté en série à une ou plusieurs configurations d'électrode dans une région source de lumière adjacente (71) au travers d'un module d'ajustement de résistance (77), le fil de source de lumière étant connecté en parallèle à d'autres fils source de lumière.

14. Un écran à cristaux liquides comprenant :
un panneau à cristaux liquides (31) pour afficher une image ; et un dispositif (70 ; 170 ; 270 ; 370) selon l'une des revendications 1, 2, 3, 7, 8, 9 ou 11, le dispositif émetteur de lumière (70 ; 170 ; 270 ; 370) pour fournir de la lumière au panneau à cristaux liquides (31).
